# EUROPEAN PATENT SPECIFICATION

(11) **EP 1 807 549 B1**
(45) Date of publication and mention of the grant of the patent: **12.01.2011**
(21) Application number: 05782911.1
(22) Date of filing: 25.08.2005
(51) Int. Cl.: C23C 18/16, C23C 18/18, C23C 18/48, H05K 3/42

(54) **METHOD FOR COATING SUBSTRATES CONTAINING ANTIMONY COMPOUNDS WITH TIN AND TIN ALLOYS**
VERFAHREN ZUM BESCHICHTEN VON ANTIMONVERBINDUNGEN ENTHALTENDEN SUBSTRATEN MIT ZINN UND ZINNLEGIERUNGEN
PROCÉDÉ POUR ENROBER DES SUBSTRATS CONTENANT DES COMPOSÉS D'ANTIMOINE AVEC DE L'ÉTAIN ET DES ALLIAGES D'ÉTAIN

(30) Priority: 27.08.2004 EP 04090330
(43) Date of publication of application: 18.07.2007
(73) Proprietor: ATOTECH Deutschland GmbH, 10553 Berlin (DE)
(72) Inventor: LOWINSKI, Christian, 16562 Bergfelde (DE); SCHREIER, Hans-Jürgen, 16727 Velten (DE); STEINBERGER, Gerhard, 13189 Berlin (DE); NAUMAN, Jana, 12157 Berlin (DE)
(74) Representative: Albrecht, Thomas
(86) International application number: PCT/EP2005/009201
(87) International publication number: WO 2006/021445

(56) References cited:
- EP-A- 0 460 786
- EP-A- 0 926 264
- WO-A-99/13696
- DE-A1- 19 857 290

## Description

The present invention relates to a method for the currentless deposition of tin and tin alloy layers on substrates containing antimony compounds such as antimony trioxide. The method is particularly suitable for producing joinable tin and tin alloy final layers on printed circuit boards containing antimony compounds, the tin and tin alloy final layers being applied onto copper portions of the conductor pattern, which are not covered by the solder stop mask. As used herein, the term "joinability" means the bondability or solderability of surfaces.

In this context antimony compounds serve as flameproofing agents and to improve the stampability for producing through-holes.

During the production of printed circuit boards final layers for producing the joinability are applied onto copper portions of the conductor pattern which are not covered by the solder stop mask, in one of the last production steps. The portions of the printed circuit boards, which are not covered by the copper layer, are particularly those portions of the surface which are not structured by conductor lines. In these portions the base material comes into direct contact with the solution used for the terminal metallization, e.g., using tin.

For this purpose, currentlessly deposited tin and tin alloy layers gain a still increasing market share. This is attributed both to the insensitive, reliable method having a wide processing range and to the excellent solderability of tin and tin alloys even after multiple high temperature exposures. Therefore, this layer is superior compared to simple organic protective layers. Furthermore, the method is more cost-effective compared to, for example, applying a nickel gold layer.

The term "currentless deposition method" refers to those methods, wherein no external power source is used as it is used in galvanisation methods. In a reduction bath the electrons required for depositing a metal are provided by the electrolyte. The baths comprise reducing agents such as sodium hypophosphite, formaldehyde or boranes being capable of reducing metal ions to the corresponding metals. No reducing agents are required in case of exchange baths because the dissolved metal ions are capable of directly reacting with the respective surface due to the potential difference. Typical examples for this case are gold on nickel and tin or silver on copper.

In the following, currentless methods are described in more detail.

There are various per se known methods available for applying the joinable tin and tin alloy final layer, which are described in the state of the art.

In addition to pure tin layers also alloys such as tin-silver, tin-bismuth, tin-lead, tin-zinc, tin-nickel, can be applied according to said method.

Already for a long time tin final layers are applied according to currentless methods to coat the surfaces of work pieces with copper or copper alloys with the purpose of forming corrosion resistant surfaces. In these currentless methods the base metal is dissolved as a compensation for the tin ions deposited.

Tin coatings are applied on copper surfaces or on surfaces of alloys on a copper basis by a certain kind of currentless plating by displacement, i.e., immersion plating techniques, such as those disclosed in US 2,891,871, US 3,303,029 and US 4,715,894. In these disclosed tin immersion plating techniques a bath is produced which contains an aqueous solution of a tin(II) salt, and acid, and thiourea or a thiourea derivative as substantial components. In said tin immersion plating method an article having a copper surface such as a copper plated circuit board, is immersed into a plating bath for a time period, during which the metallic copper at the surface is oxidized to copper(I) and complexed by thiourea and is displaced at the surface by metallic tin which is obtained by the simultaneous reduction of tin(II) ions. After the desired thickness has been achieved by displacement plating, the article is removed from the bath and rinsed to remove the remaining plating solution.

Currentless displacement plating is used in the manufacture of printed circuit boards (PCBs) and, particularly, in the manufacture of multilayer printed circuit boards. Printed circuit boards comprise a non-conducting or dielectric board such as a glass fibre/epoxy board which is plated with a conductive metal layer such as copper on one surface or on both surfaces. Prior to the processing, the metal layer on the PCB is typically a continuous copper layer which may be interrupted by a pattern of plated through-holes or connection contacts connecting both surfaces of the board. During the processing selected portions of the copper layer are removed to form an elevated copper wiring picture pattern of the PCB. Multilayer PCBs are typically assembled by nesting mapped conducting layers such as a copper-containing layer, with dielectric adhesive layers such as a partially cured B-stage resin, i.e., a prepreg, to form a multilayer sandwich which is, subsequently, linked by heat and pressure. The manufacture of these types of printed circuit boards is described in "Printed Circuits Handbook", 3rd edition, edited by C. F. Coombs, Jr., McGraw Hill, 1988. Since a conductive layer having a smooth copper surface is not well-suited for being bonded to the prepreg, different treatments of the copper surface for increasing the bonding strength between the layers of the multilayer PCB sandwich have been developed.

Such a treatment of the copper surface is the use of immersion tin and tin alloy compositions as a bonding medium for multilayer circuits as disclosed by Holtzman et al. in US 4,175,894. The method discloses an immersion tin composition containing both thiourea compounds and urea compounds for plating the copper surface of each PCB by means of the immersion method by replacing tin before being laminated to form a multilayer printed circuit board.

US 5,435,838 describes a method for the currentless deposition of a tin bismuth alloy on copper surfaces. In this method tin and bismuth are employed in the form of their methane sulfonates. Thiourea is used as a complexing agent for forming a complex with the copper dissolved from the surface.

However, the described methods for depositing tin and tin alloys are not suitable for coating substrates containing antimony compounds. Antimony compounds are widespread in industry and are used as flameproofing agents and for improving the stampability such as in the production of printed circuit boards.

This restriction significantly limits the scope of application of chemical methods for applying tin. It is, therefore, the object underlying the present invention to provide a method which can be successfully applied also for the described class of substrates.

Among this class of substrates containing antimony compounds there are, for example, printed circuit boards which use so-called CEM-1 as a cost-effective base material. This material has the advantage that drilling holes which is one of the most complex and most expensive steps in the manufacture of printed circuit boards can be replaced by a simple stamping process. Until now it has not been possible to coat CEM-1 materials according to a currentless tin method. The reason is the use of antimony compounds, in particular, antimony trioxide as a flameproofing agent and for improving the stampability of the base material. Therefore, exemplarily the company Isola USA describes the content of antimony trioxide in its base material 65M62 to be 5.74%. During the process steps the antimony trioxide is dissolved out of the base material at the edges and at the stamped holes. As a result, a turbidity and dark precipitations in the baths for depositing tin and tin alloys occur. The deposited tin layers exhibit dark stains. Thus, their properties as joinable final layers are not sufficient.

Furthermore, the baths for depositing tin and tin alloys cannot be used for the production of metallized substrates already after coating few printed circuit boards. Thus, a commercially reasonable application of coating tin onto CEM-1 printed circuit boards is not possible.

WO 94/26082 relates to a method for through-connecting printed circuit boards by means of conductive plastics for direct metallization, wherein a polymer layer having an intrinsic electric conductivity is applied fixedly onto non-conductive positions of the printed circuit boards. A metal layer is applied thereon. The method does not use an oxidative pretreatment of the printed circuit boards. Among others, CEM is indicated as a substrate material. The substrate material can be pretreated by certain method measures comprising mechanical cleaning, rinsing and etching (cf. page 8, lines 1-4 of WO 94/26082).

Finally, WO 94/26082 states, inter alia, tin as metal suitable for metallization (cf. page 10, lines 31- page 11, line 3).

EP 0 926 264 A2 describes an aqueous, strongly acidic exchange bath for currentlessly depositing tin onto copper comprising tin(II) salts, thiourea or its derivatives, thiohydantoin, a fine grain additive for tin, an emulsifier and a surfactant.

Applicant's WO 99/13696 relates to a method for metallizing a substrate having non-conductive surface portions wherein the substrate is treated with a noble metal colloid solution and, subsequently, with an etching solution containing hydrogen ions in a concentration of not more than 0.5 mol/kg solution and hydrogen peroxide. Then a first metal layer is produced on the non-conductive surfaces by currentless metal deposition and a second metal layer is applied thereon by electrolytic metal deposition.

The method includes the use of hydrogen peroxide as an oxidizing agent.

Surprisingly, the problems described can be solved by a simple pretreatment of the substrate materials containing antimony with a pretreatment solution by which the antimony compounds can be removed from the surface.

Therein, the pretreatment solution used according to the present invention does not contain any oxidizing agents such as the peroxides commonly used in etching processes (mostly in combination with sulfuric acid) such as hydrogen peroxide, peroxodisulfates or persulfates. The use of such oxidizing agents results in the metals being peeled off from a metallic substrate such as copper of a printed circuit board. Thus, the surfaces are roughened. The pretreatment solution used according to the present invention contains a strong acid solution as an essential component which may contain impurities entrained from the production method of the acid solution. Acids having a technical purity grade can thus be used in the pretreatment solution used according to the present invention.

By applying the method according to the present invention, the interfering effect of the antimony compounds contained in the substrate can be reduced to such an extent that the undesired precipitation is avoided. When the method according to the present invention is applied, the tin layers deposited exhibit an excellent quality with respect to the joinability and the durability and the useful life of the tin bath can be extended such that an economic application becomes possible.

The subject of the present invention is a method for the currentless metallization of substrate materials containing antimony compounds with tin or tin alloys, comprising the etching, the metallization with a tin salt solution and rinsing the substrate material, characterized in that the method further comprises a pretreatment step wherein the substrate material is contacted with a pretreatment solution prior to the metallization, the pretreatment solution comprising a solution of a strong acid, being free of oxidizing agents and removing the antimony compounds from the surface of the substrate material prior to the metallization.

Strong acids such mineral acids (sulfuric acid, nitric acid, hydrochloric acid) or strong organic acids such as alkane sulfonic acids can be used as pretreatment solutions.

As it is known to the person skilled in the art, the strength of an acid in an aqueous solution results from the equilibrium constant Kₛ(=Kₐ) of the reaction HX+H₂O ⇄ H₃O⁺+X⁻wherein X⁻ represents the anion of the acid.

The term "strong acids" refers to such acids having an acidity constant Kₛ of 55.34 to 3.16 · 10⁻⁵ corresponding to a pKₛ of -1.74 to 4.5. Acids having a pKₛ in the indicated range are used according to the present invention.

The concentration of the sulfuric acid in the pretreatment solution used according to the present invention is 5-60% (parts by weight of the acid / parts by weight of the solution), preferably 10-30%; the concentration of nitric acid is 5-40%, preferably, 5-25%. For example, methane sulfonic acid in a concentration of 5-70%, preferably 10-40% can be used as an alkane sulfonic acid. The salts of the acid such as the sodium salt or the potassium salt of methane sulfonic acid can also be used instead of the acids. In the context of the present invention, the term "acid solution" designates an aqueous solution of the acid or its salts. Therefore, also a sodium methanesulfonate solution or a potassium methanesulfonate solution is an acid solution for use in the method according to the present invention.

In a particularly preferred embodiment of the method according to the present invention, the substrates to be coated are treated with a hydrochloric acid pretreatment solution. The content of hydrochloric acid is 5-38%, preferably 10-30%, particularly preferred 15-25% HCl.

The method according to the present invention is usually carried out at a temperature within the range of 15-80°C, preferably 30-70°C, and most preferably 50-65°C. Depending on the pretreatment solution used, particularly on the concentration of the pretreatment solution used, the treatment period is generally within the range of 1-60 minutes, preferably 1-25 minutes, and particularly preferred 2-10 minutes.

In the method according to the present invention the antimony compounds dissolved in the pretreatment solution can deposit on the copper surface of the printed circuit boards in the form of antimony. These deposited metal layers can optionally be removed again by a microetching solution.

Such microetching solutions as those usually used to clean copper prior to being coated with tin or other final layers are known in the art and practically often consist of an aqueous solution of alkali metal peroxodisulfates or hydrogen peroxide in combination with sulfuric acid. An etching solution for the surface treatment of copper is described in US 6,036,758, the etching solution containing hydrogen peroxide and an aromatic sulfonic acid or its salt. Additionally, this etching solution contains inter alia an inorganic acid, particularly preferred sulfuric acid. An etching (polishing) solution is known from EP 1 167 482, which contains an N-heterocyclic compound, hydrogen peroxide and a salt of dodecyl benzene sulfonic acid.

Such microetching solutions can further be solutions containing sulfuric acid and peroxodisulfate or its salts or caroates.

The printed circuit board pretreated according to the method of the present invention can subsequently be metallized chemically in a tin bath. Thereby, the strong dark turbidity of the bath which can otherwise be observed and the formation of stains do not occur. The tin final layer exhibits the desired properties such as an excellent joinability and durability.

When the pretreatment of a substrate material containing antimony is carried out on a commercial scale, the pretreatment solution according to the present invention has to be replaced continuously because the concentration of antimony dissolved therein increases and, consequently, the antimony deposits on the tin copper layers to be coated with tin. This negatively affects the surface properties of the consecutive tin final layer with respect to durability and joinability. In fact, the antimony can be removed again from the copper by extended etching periods in the microetching step. However, in case of high concentrations of antimony in the pretreatment solution the time required for the etching step becomes too long, affecting the cost-effectiveness of the method.

Therefore, it is suggested in an embodiment of the present invention to remove antimony from the pretreatment solution by depositing the antimony on an additional metal.

For this purpose, the pretreatment solution containing antimony compounds is continuously or discontinuously passed over a column containing a metal on which the dissolved antimony species deposits from the pretreatment solution in the form of antimony. The metal can also be added directly to the pretreatment solution. Examples for such metals comprise copper, iron, nickel, cobalt, tin and zinc. The metal can be in the form of granules, rods, bars or spheres, on the surface of which the dissolved antimony deposits.

When the capacity of the column is exhausted due to the surface being completely covered with antimony, the column can be regenerated after thorough rinsing by introducing a microetching solution as already described above. After that the column is again available for regenerating the pretreatment solution. The service life of the pretreatment solution can be extended significantly by this measure.

Minor residues of antimony which still deposit on the substrate material and which are dissolved in the tin bath during the metallization can be removed from the tin bath by an additional measure.

For this purpose, the tin bath is continuously or discontinuously passed over metallic tin or metallic tin is directly added to the tin bath. Thereby, antimony contained in the tin bath deposits on the metallic tin and is thus removed from the bath cycle.

To avoid the tin ions concentrating in the tin bath, regeneration methods known in the art can be used. Preferably the regeneration unit disclosed in DE 101 32 478 is used to achieve a constant concentration of tin ions in the solution.

The measures described enable an effective chemical metallization of substrate materials containing antimony such as CEM-1 with tin. The service life of baths for depositing tin and tin alloys is strongly increased and the quality of the resulting layers is positively influenced with respect to durability and joinability. The pretreatment solution used in the method according to the present invention can be regenerated in a further process step. Thereby, the waste water problem is solved to a large extent and the method additionally gains profitability. Antimony residues which are still leached out of the substrate material in the tin bath and become dissolved, are removed by the regeneration of the tin bath described above by means of metallic tin.

The present invention is described in more detail by means of the following examples.

### Example 1:

A printed circuit board made of CEM-1 material having dimensions of 5 x 5 cm is treated with an aqueous solution containing 18% hydrochloric acid at a temperature of 50°C for five minutes. Then the material is treated with a microetching solution "Micro Etch SF", available from Atotech, which essentially contains a sulfuric acid solution of peroxodisulfate, at a temperature of 35°C for one minute and is subsequently metallized with tin by employing Atotech's method for the chemical deposition of tin, comprising the following two steps:
1. Treatment with Stannadip F, essentially containing an acidic solution of tin(II) methanesulfonate und thiourea at room temperature for one minute;
2. Treatment with Stannatech F, essentially containing an acidic solution of tin(II) methanesulfonate und thiourea at a temperature of 60°C for five minutes.

After the treatment the printed circuit boards are rinsed with de-mineralized water and dried at a temperature of 60°C.

The tin layer deposited exhibits a thickness of about 0.5 µm, an excellent durability and excellent joining properties in terms of solderability.

The procedure described is repeated for a total of five times. Thereby, the baths for chemical metallization of the printed circuit boards maintain their initial properties. The described turbidity and the dark precipitations in the tin bath do not occur. The tin layers deposited do not exhibit any dark stains and their surface properties are maintained.

### Example 2:

A printed circuit board made of CEM-1 material having dimensions of 5 x 5 cm is treated with an aqueous solution containing 10% hydrochloric acid at a temperature of 60°C for five minutes. Then the material is treated with a microetching solution "Micro Etch SF", available from Atotech, at a temperature of 35°C for one minute and is subsequently metallized with tin by using Atotech's method for the chemical deposition of tin, comprising the following two steps:
1. Treatment with Stannadip F at room temperature for one minute;
2. Treatment with Stannatech F at a temperature of 60°C for five minutes.

After the treatment the printed circuit boards are rinsed with VE-water and dried at a temperature of 60°C.

The tin layer deposited exhibits a thickness of about 0.5 µm, an excellent durability and excellent joining properties in terms of solderability.

The procedure described is repeated for a total of five times. Thereby, the baths for chemical metallization of the printed circuit boards maintain their initial properties. The described turbidity and the dark precipitations in the tin bath do not occur. The tin layers deposited do not exhibit any dark stains and their surface properties are maintained.

### Example 3:

The aqueous solution containing 18 % hydrochloric acid for the pretreatment of the printed circuit boards is used in accordance with Example 1. A portion of the solution is continuously removed from the bath and passed over a column filled with copper granules. Thereby, antimony deposits at the surface of the granules. When the copper surface is covered with metallic antimony to a large extent, the antimony is dissolved by treating with Atotech's microetching solution "Micro Etch SF", the solution is removed from the column and supplied to the waste water treatment. The use of this method enabled the treatment of more than 50 printed circuit boards with the hydrochloric acid solution without the necessity of replacing the solution.

The pretreated printed circuit boards are processed in accordance with Example 1 or 2.

### Example 4:

A portion of the Stannatech F-solution for metallizing the substrate with tin according to Example 1 is continuously removed from the bath and passed over a column filled with tin granules. Thereby, antimony deposits on the surface of the granules. When the tin surface is covered with metallic antimony to a large extent, the antimony is dissolved by treating with Atotech's microetching solution "Micro Etch SF", the solution is removed from the column and supplied to the waste water treatment.

The undesired deposition of antimony on the printed circuit boards is prevented by the treatment virtually completely.

### Example 5:

The Stannatech F-solution for metallizing the substrate with tin in accordance with Example 1 is added with 50 g tin granules. Thereby, antimony deposits on the surface of the granules. When the tin surface is covered with metallic antimony to a large extent, the tin granules are removed from the metallizing solution and the antimony is dissolved by treating the covered granules with Atotech's microetching solution "Micro Etch SF", the solution is supplied to the waste water treatment and the tin granules set free from antimony are supplied back into the metallization solution.

The undesired deposition of antimony on the printed circuit board is prevented virtually completely by the treatment.

### Comparative Examples

### Comparative Example 1:

A printed circuit board made of CEM-1 material having dimensions of 5 x 5 cm is treated with Atotech's cleaning agent Pro Select SF which is employed as a standard agent in the conventional metallization of printed circuit boards, at a temperature of 40°C for five minutes. Then the material is treated with Atotech's microetching solution "Micro Etch SF" at a temperature of 35°C for one minute and is subsequently metallized with tin. For this purpose, Atotech's method for the chemical deposition of tin is employed, the method comprising the following two steps:
1. Treatment with Stannadip F at room temperature for one minute;
2. Treatment with Stannatech F at a temperature at 60°C for five minutes.

After the treatment the printed circuit boards are rinsed with VE-water and dried at a temperature of 60°C.

The tin layer deposited initially exhibits an at least sufficient joinability at a thickness of about 0.5 µm.

The Stannatech bath loses its initial properties already in the next metallization step. A turbidity and the formation of dark precipitations occur in the tin bath. The tin layer deposited exhibits dark stains and loses its desired surface properties. The properties of the tin bath deteriorate rapidly in the following. Already after the fourth step the metallization is incomplete and the bath cannot be used any more.

### Comparative Example 2:

A printed circuit board made of CEM-1 material having the size of 5 x 5 cm is treated without pretreatment with Atotech's microetching solution "Micro Etch SF" at a temperature of 35°C for one minute and is subsequently metallized with tin. For this purpose, Atotech's method for the chemical deposition of tin is employed, the method comprising the following two steps:
1. Treatment with Stannadip F at room temperature for one minute;
2. Treatment with Stannatech F at a temperature at 60°C for five minutes.

After the treatment the printed circuit boards are rinsed with VE-water and dried at a temperature of 60°C.

The tin layer deposited initially exhibits an at least sufficient joinability at a thickness of about 0.5 µm.

However, already in the metallization step the Stannatech bath loses its initial properties. A turbidity and the formation of dark precipitations occur in the tin bath. The tin layer deposited exhibits dark stains and loses its desired surface properties. The properties of the tin bath deteriorate rapidly in the following. Already after few method steps the metallization is incomplete. The bath has to be discarded.

## Claims

1. Method for the currentless metallization of substrate materials containing antimony compounds with tin or tin alloys, comprising etching, metallization with a tin salt solution and rinsing the substrate material, **characterized in that** the method further comprises a pretreatment step, wherein the substrate material is contacted with a pretreatment solution prior to metallization, the pretreatment solution comprising a strong hydrochloric acid solution, being free of oxidizing agents and removing the antimony compounds from the surface of the substrate material prior to metallization.

2. Method according to claim 1, **characterized in that** a hydrochloric acid solution having a concentration of 5-38% is used as the pretreatment solution.

3. Method according to claim 2, **characterized in that** a hydrochloric acid solution having a concentration of 10-30% is used as the pretreatment solution.

4. Method according to claim 3, **characterized in that** a hydrochloric acid solution having a concentration of 15-25% is used as the pretreatment solution.

5. Method according to any one of claims 1-4, **characterized in that** the antimony compounds dissolved in the pretreatment solution are removed from the solution by deposition in a chemical exchange reaction against a metal.

6. Method according to claim 5, **characterized in that** the solution is passed either continuously or discontinuously over a column filled with a metal to deposit the antimony in a chemical exchange reaction.

7. Method according to claim 5, **characterized in that** a metal is directly added to the pretreatment solution to deposit the antimony in a chemical exchange reaction.

8. Method according to any one of claims 5-7, **characterized in that** the metal for depositing antimony in a chemical exchange reaction is in the form of granules, rods, bars or spheres.

9. Method according to any one of claims 5-8, **characterized in that** the metal for depositing antimony in a chemical exchange reaction is selected from the group comprising copper, iron, nickel, cobalt, tin and zinc.

10. Method according to any one of claims 5-9, **characterized in that** the antimony layer which has been formed on a metal in a chemical exchange reaction, is removed again by treatment with a microetching solution.

11. Method according to any one of claims 1-10, **characterized in that** the antimony compounds contained in the solution used for the metallization with tin or tin alloys are removed from the solution by deposition in a chemical exchange reaction against metallic tin.

12. Method according to claim 11, **characterized in that** the solution is passed either continuously or discontinuously over a column filled with metallic tin to deposit the antimony in a chemical exchange reaction.

13. Method according to claim 11 or 12, **characterized in that** the antimony layer, which has been formed on the tin by a chemical exchange reaction, is removed again by treatment with a microetching solution.

14. Method according to any one of claims 1-13, **characterized in that** the tin or tin alloy coating is effected from a metallization solution containing tin (II) methanesulfonate as a tin source.

15. Method according to any one of claims 1-13, **characterized in that** the tin or tin alloy coating is effected from a metallization solution containing thiourea.

16. Use of the method according to any one of claims 1-5 for producing joinable layers of tin or tin alloys.

17. Use of the method according to any one of claims 1-5 in the manufacture of a substrate for electric circuitry or in the semiconductor technology in vertical and/or horizontal devices.

18. Use of the method according to claim 17, **characterized in that** the supports for electric circuitry are printed circuit boards.

## Patentansprüche

1. Verfahren zur stromlosen Metallisierung von Substratmaterialien, die Antimonverbindungen enthalten, mit Zinn oder Zinnlegierungen, umfassend Ätzen, Metallisierung mit einer Zinnsalzlösung und Spülen des Substratmaterials, **dadurch gekennzeichnet, dass** das Verfahren außerdem einen Vorbehandlungsschritt umfasst, in dem das Substratmaterial vor Metallisierung mit einer Vorbehandlungslösung in Kontakt gebracht wird, wobei die Vorbehandlungslösung eine starke Salzsäurelösung umfasst, frei von Oxidationsmitteln ist und die Antimonverbindungen von der Oberfläche des Substratmaterials vor Metallisierung entfernt.

2. Verfahren nach Anspruch 1, **dadurch gekennzeichnet, dass** eine Salzsäurelösung mit einer Konzentration von 5-38% als die Vorbehandlungslösung verwendet wird.

3. Verfahren nach Anspruch 2, **dadurch gekennzeichnet, dass** eine Salzsäurelösung mit einer Konzentration von 10-30% als die Vorbehandlungslösung verwendet wird.

4. Verfahren nach Anspruch 3, **dadurch gekennzeichnet, dass** eine Salzsäurelösung mit einer Konzentration von 15-25% als die Vorbehandlungslösung verwendet wird.

5. Verfahren nach einem der Ansprüche 1 bis 4, **dadurch gekennzeichnet, dass** die Antimonverbindungen, die in der Vorbehandlungslösung gelöst sind, durch Abscheidung in einer chemischen Austauschreaktion gegen ein Metall aus der Lösung entfernt werden.

6. Verfahren nach Anspruch 5, **dadurch gekennzeichnet, dass** die Lösung kontinuierlich oder diskontinuierlich über eine Säule, die mit einem Metall gefüllt ist, geleitet wird, um das Antimon in einer chemischen Austauschreaktion abzuscheiden.

7. Verfahren nach Anspruch 5, **dadurch gekennzeichnet, dass** ein Metall direkt zu der Vorbehandlungslösung gegeben wird, um das Antimon in einer chemischen Austauschreaktion abzuscheiden.

8. Verfahren nach einem der Ansprüche 5-7, **dadurch gekennzeichnet, dass** das Metall zur Abscheidung von Antimon in einer chemischen Austauschreaktion in der Form von Granulat, Stangen, Stäben oder Kügelchen ist.

9. Verfahren nach einem der Ansprüche 5-8, **dadurch gekennzeichnet, dass** das Metall zur Abscheidung von Antimon in einer chemischen Austauschreaktion aus der Gruppe, umfassend Kupfer, Eisen, Nickel, Kobalt, Zinn und Zink, ausgewählt wird.

10. Verfahren nach einem der Ansprüche 5-9, **dadurch gekennzeichnet, dass** die Antimonschicht, die in einer chemischen Austauschreaktion auf einem Metall gebildet wurde, durch Behandlung mit einer Mikroätzlösung wieder entfernt wird.

11. Verfahren nach einem der Ansprüche 1-10, **dadurch gekennzeichnet, dass** die Antimonverbindungen, die in der Lösung enthalten sind, die zur Metallisierung mit Zinn oder Zinnlegierungen verwendet wird, aus der Lösung durch Abscheidung in einer chemischen Austauschreaktion gegen metallisches Zinn entfernt werden.

12. Verfahren nach Anspruch 11, **dadurch gekennzeichnet, dass** die Lösung entweder kontinuierlich oder diskontinuierlich über eine Säule, die mit metallischem Zinn gefüllt ist, geleitet wird, um das Antimon in einer chemischen Austauschreaktion abzuscheiden.

13. Verfahren nach Anspruch 11 oder 12, **dadurch gekennzeichnet, dass** die Antimonschicht, die auf dem Zinn durch eine chemische Austauschreaktion gebildet wurde, durch Behandlung mit einer Mikroätzlösung wieder entfernt wird.

14. Verfahren nach einem der Ansprüche 1-13, **dadurch gekennzeichnet, dass** die Zinn- oder Zinnlegierungsbeschichtung aus einer Metallisierungslösung, die Zinn(II)-Methansulfonat als Zinnquelle enthält, erfolgt.

15. Verfahren nach einem der Ansprüche 1-13, **dadurch gekennzeichnet, dass** die Zinn- oder Zinnlegierungsbeschichtung aus einer Metallisierungslösung, die Thioharnstoff enthält, erfolgt.

16. Verwendung des Verfahrens nach einem der Ansprüche 1-5 zur Produktion verbindbarer Schichten aus Zinn oder Zinnlegierungen.

17. Verwendung des Verfahrens nach einem der Ansprüche 1-5 bei der Herstellung eines Substrats für eine elektrische Schaltkreisanordnung oder in der Halbleitertechnologie in vertikalen und/oder horizontalen Vorrichtungen.

18. Verwendung des Verfahrens nach Anspruch 17, **dadurch gekennzeichnet, dass** die Träger für eine elektrische Schaltungsanordnung gedruckte Leiterplatten sind.

## Revendications

1. Procédé de métallisation sans courant de matériaux de substrat contenant des composés d'antimoine avec de l'étain ou des alliages d'étain, comprenant un décapage, une métallisation avec une solution de sel d'étain et un rinçage du matériau de substrat, **caractérisé en ce que** le procédé comprend en outre une étape de prétraitement, dans lequel le matériau de substrat est mis en contact avec une solution de prétraitement avant la métallisation, la solution de prétraitement comprenant une solution concentrée en acide chlorhydrique, étant exempte d'agents oxydants et éliminant les composés d'antimoine de la surface du matériau de substrat avant la métallisation.

2. Procédé selon la revendication 1, **caractérisé en ce qu'**une solution d'acide chlorhydrique ayant une concentration allant de 5 % à 38 % est utilisée en tant que solution de prétraitement.

3. Procédé selon la revendication 2, **caractérisé en ce qu'**une solution d'acide chlorhydrique ayant une concentration allant de 10 % à 30 % est utilisée en tant que solution de prétraitement.

4. Procédé selon la revendication 3, **caractérisé en ce qu'**une solution d'acide chlorhydrique ayant une concentration allant de 15 % à 25 % est utilisée en tant que solution de prétraitement.

5. Procédé selon l'une quelconque des revendications 1 à 4, **caractérisé en ce que** les composés d'antimoine dissous dans la solution de prétraitement sont éliminés de la solution par dépôt dans une réaction d'échange chimique par échange avec un métal.

6. Procédé selon la revendication 5, **caractérisé en ce que** la solution est passée soit de manière continue, soit de manière discontinue sur une colonne chargée avec un métal pour déposer l'antimoine dans une réaction d'échange chimique.

7. Procédé selon la revendication 5, **caractérisé en ce qu'**un métal est directement ajouté à la solution de prétraitement pour déposer l'antimoine dans une réaction d'échange chimique.

8. Procédé selon l'une quelconque des revendications 5 à 7, **caractérisé en ce que** le métal servant à déposer l'antimoine dans une réaction d'échange chimique est sous la forme de granulés, de bâtonnets, de barres ou de sphères.

9. Procédé selon l'une quelconque des revendications 5 à 8, **caractérisé en ce que** le métal servant à déposer l'antimoine dans une réaction d'échange chimique est choisi dans le groupe comprenant le cuivre, le fer, le nickel, le cobalt, l'étain et le zinc.

10. Procédé selon l'une quelconque des revendications 5 à 9, **caractérisé en ce que** la couche d'antimoine qui a été formée sur un métal dans une réaction d'échange chimique est à nouveau éliminée par traitement avec une solution de microdécapage.

11. Procédé selon l'une quelconque des revendications 1 à 10, **caractérisé en ce que** les composés d'antimoine contenus dans la solution utilisée pour la métallisation avec de l'étain ou des alliages d'étain sont éliminés de la solution par dépôt dans une réaction d'échange chimique par échange avec de l'étain métallique.

12. Procédé selon la revendication 11, **caractérisé en ce que** la solution est passée soit de manière continue, soit de manière discontinue sur une colonne chargée avec de l'étain métallique pour déposer l'antimoine dans une réaction d'échange chimique.

13. Procédé selon la revendication 11 ou 12, **caractérisé en ce que** la couche d'antimoine, qui a été formée sur l'étain par une réaction d'échange chimique, est à nouveau éliminée par traitement avec une solution de microdécapage.

14. Procédé selon l'une quelconque des revendications 1 à 13, **caractérisé en ce que** le revêtement d'étain ou d'alliage d'étain est effectué à partir d'une solution de métallisation contenant du méthanesulfonate d'étain (II) en tant que source d'étain.

15. Procédé selon l'une quelconque des revendications 1 à 13, **caractérisé en ce que** le revêtement d'étain ou d'alliage d'étain est effectué à partir d'une solution de métallisation contenant de la thiourée.

16. Utilisation du procédé selon l'une quelconque des revendications 1 à 5, pour produire des couches assemblables d'étain ou d'alliages d'étain.

17. Utilisation du procédé selon l'une quelconque des revendications 1 à 5, dans la fabrication d'un substrat pour circuit électrique ou dans la technologie des semi-conducteurs dans des dispositifs verticaux et/ou horizontaux.

18. Utilisation du procédé selon la revendication 17, **caractérisé en ce que** les supports de circuit électrique sont des cartes de circuit imprimé.
